# EUROPÄISCHE PATENTSCHRIFT

(11) **EP 1 967 610 B1**
(45) Veröffentlichungstag und Bekanntmachung des Hinweises auf die Patenterteilung: **07.11.2012**
(21) Anmeldenummer: 08003421.8
(22) Anmeldetag: 26.02.2008
(51) Int. Cl.: C23C 16/448, C23C 16/52, B01J 4/00, F04C 25/02

(54) **Fördereinrichtung für Precursor**
Handling device for precursor
Dispositif de transport pour précurseur

(30) Priorität: 08.03.2007 DE 102007011589
(43) Veröffentlichungstag der Anmeldung: 10.09.2008
(73) Patentinhaber: Schott AG, 55122 Mainz (DE)
(72) Erfinder: Bauch, Hartmut, 61276 Weilrod (DE); Gudgel, Todd, Dr., Morton Grove, IL 60053, (US)
(74) Vertreter: Blumbach - Zinngrebe

(56) Entgegenhaltungen:
- EP-A- 0 479 375
- WO-A-01/46592
- JP-A- 7 217 537
- JP-A- 60 046 373
- JP-A- 2003 268 551
- US-A1- 2006 060 139

## Beschreibung

Die Erfindung betrifft im Allgemeinen eine Fördereinrichtung für die Zuführung eines gasförmigen Precursors zur Weiterverarbeitung sowie ein Verfahren zum Fördern eines gasförmigen Precursors nach den Oberbegriffen der unabhängigen Ansprüche. Die Erfindung betrifft im Speziellen das Fördern eines Precursors in einem Trägergasstrom.

Im Rahmen der vorliegenden Anmeldung wird der Begriff "Precursor" für das Ausgangsmaterial einer in der Weiterverarbeitung des Precursors zu bildenden Beschichtung verwendet. Der Begriff "Precursor" bezeichnet dabei den oder die Vorläufer derjenigen Verbindung oder Verbindungen, welche die Beschichtung bilden. Ein Precursor kann demnach eine oder mehrere Substanzen umfassen.

In dem Dokument EP 0 479 375 A1 ist ein Verfahren zur CVD-Beschichtung eines Substrats in einer Kammer beschrieben, wobei in einem Vorlagegefäß Dampf erzeugt und zur Kammer durch eine Leitung geleitet wird. Der Dampf wird dabei von einer Pumpe durch die Leitung gepumpt. Die Leitung wird dabei auf einem solchen Druckniveau gehalten, dass der Dampf nicht kondensiert. Es ist hierzu eine mit einem Drucksensor unmittelbar vor der Pumpe verbundene Steuereinheit vorgesehen, welche ein entsprechendes Ventil vor der Pumpe steuert, um den Dampf auf dem gewünschten Druck zu halten. Um die Menge an Dampf auf einfache Weise beeinflussen zu können, ist die Zugabe eines Inertgases wie Helium erwähnt.

Das Dokument JP 2003-268551 A zeigt ein Zufuhrsystem für bei Raumtemperatur und Atmosphärendruck feste oder flüssige Precursor-Materialien in eine CVD-Beschichtungsanlage. Alle Leitungen, durch die der Precursor geleitet wird, werden mittels einer Heizvorrichtung beheizt, um das Kondensieren von Precursor-Material zu verhindern.

Für die Förderung und gegebenenfalls auch Dosierung eines Precursors, welcher unter den am Eingang zu einer Weiterverarbeitung - wie etwa am Eingang zu einer CVD-Beschichtungsanlage - herrschenden Bedingungen einen Dampfdruck hat, der geringer ist als der Druck an diesem Eingang beziehungsweise der Druck in einem Prozeßgasstrom, können prinzipiell Vakuumpumpen eingesetzt werden. Es besteht jedoch die Gefahr, daß der Sättigungsdampfdruck bei der Förderung des Precursors durch die Vakuumpumpe erreicht wird und der Precursor in der Pumpe kondensiert.

Dies kann zum einen die Leistungsfähigkeit der Pumpe negativ beeinflussen. Zum anderen ist insbesondere für Beschichtungsverfahren wie chemische Gasphasenabscheidung (chemical vapour deposition, CVD), chemische Gasphasenabscheidung durch Verbrennung (combustion chemical vapour deposition, CCVD), insbesondere Flammpyrolyse, Plasma induzierte chemische Gasphasenabscheidung (plasma enhanced chemical vapour deposition, PECVD) und gepulste Plasma induzierte chemische Gasphasenabscheidung (plasma impulse chemical vapour deposition, PICVD) die Zufuhr eines ausschließlich gasförmig vorliegenden Precursors wichtig, um den Beschichtungsprozeß sicher durchführen zu können. Für Precursor, die bei Raumtemperatur und unter Atmosphärendruck in fester beziehungsweise flüssiger Form vorliegen, ist insbesondere für Anwendungen in Beschichtungsverfahren daher zunächst ein Verdampfen des Precursors erforderlich, und dann ein zuverlässiges Fördern und gegebenenfalls Dosieren des gasförmigen Precursors.

Es ergibt sich daher eine Aufgabe der Erfindung, eine Möglichkeit für das Fördern bei der Zuführung eines gasförmigen Precursors zur Weiterverarbeitung, insbesondere zu einer CVD-Beschichtungsanlage, bereit zu stellen, in welcher das Kondensieren des Precursors während des Förderns und Dosierens zuverlässig unterbunden wird. Eine weitere Aufgabe der Erfindung besteht darin, das Fördern möglichst einfach und wenig störanfällig durchführen zu können.

Diese Aufgaben werden erfindungsgemäß gelöst mit einem Verfahren mit den Merkmalen des unabhängigen Anspruchs 1.

Vorteilhafte Weiterbildungen sind Gegenstand der Unteransprüche.

Anspruch 1 beschreibt ein Verfahren zum Fördern eines gasförmigen Precursors zur Weiterverarbeitung mit den folgenden Schritten:
a) Bereitstellen eines bei Raumtemperatur und Atmosphärendruck festen und/oder flüssigen Precursors in einem Vorlagegefäß (3) für den festen und/oder flüssigen Precursor,
b) Verdampfen des festen und/oder flüssigen Precursors zumindest durch Absenken des Druckes über dem festen und/oder flüssigen Precursor zum Bereitstellen eines gasförmigen Precursors unter Verwendung einer Vakuumpumpe (2), wobei ein erster Leitungsabschnitt (23) auf einer Einlaßseite der Vakuumpumpe (2) eine Verbindung zwischen der Vakuumpumpe (2) und dem Vorlagegefäß (3) herstellt,
c) Mischen des gasförmigen Precursors mit einem Trägergas in der Vakuumpumpe (2), wobei das Trägergas über zumindest einen zweiten Leitungsabschnitt (24) zugeführt wird,
dadurch gekennzeichnet, dass
die Mengenströme des gasförmigen Precursors und des Trägergases mittels einer Kontrolleinrichtung (5) derart aufeinander abgestimmt werden, daß der Partialdruck des gasförmigen Precursors zumindest nach Eintritt in die Vakuumpumpe (2) unterhalb seines Sättigungsdampfdrucks gehalten wird, indem
die Kontrolleinrichtung (5) mit dem ersten und dem zweiten Leitungsabschnitt (23, 24) verbunden ist und den Mengenfluß des gasförmigen Precursors und/oder des Trägergases steuert und/oder regelt, wobei
die Kontrolleinrichtung (5) einen Speicher (8) umfaßt, in welchem zumindest ein Sättigungsdampfdruck eines Precursors abgelegt ist, und
der Speicher (8) mit einem ersten Massenflußregler (6) für den gasförmigen Precursor in dem ersten Leitungsabschnitt (23) und/oder einem zweiten Massenflußregler (7) für das Trägergas in dem zweiten Leitungsabschnitt (24) verbunden ist.

Eine Fördereinrichtung stellt für die Zuführung eines gasförmigen Precursors zur Weiterverarbeitung zur Verfügung, welche eine Vakuumpumpe zum Evakuieren eines Vorlagengefäßes für einen bei Raumtemperatur und Atmosphärendruck festen und/oder flüssigen Precursor und zum Fördern des durch das Evakuieren verdampften, gasförmigen Precursors, einen ersten Leitungsabschnitt auf der Einlaßseite der Vakuumpumpe zum Herstellen einer Verbindung zwischen der Vakuumpumpe und dem Vorlagegefäß für den festen und/oder flüssigen Precursor und zumindest einen zweiten Leitungsabschnitt für die Zuführung von Trägergas in die Vakuumpumpe umfaßt. Des Weiteren weist die Fördereinrichtung eine Kontrolleinrichtung auf, welche mit dem ersten und dem zweiten Leitungsabschnitt verbindbar ist und im Betrieb der Vorrichtung den Mengenfluß des gasförmigen Precursors und/oder des Trägergases derart steuert und/oder regelt, daß der Partialdruck des gasförmigen Precursors zumindest nach Eintritt in die Pumpe unterhalb seines Sättigungsdampfdrucks gehalten wird.

Im Rahmen der vorliegenden Anmeldung kann das Fördern des Precursors vorteilhafterweise das Dosieren des Precursors umfassen. Die Fördereinrichtung wirkt dann gleichzeitig als Dosiereinrichtung. Das Dosieren des Precursors muß aber nicht zwingend über das Fördern beziehungsweise die Fördereinrichtung erfolgen.

Unter dem Begriff "Evakuieren" wird im Rahmen der vorliegenden Anmeldung das Auspumpen von Material unter Absenkung des auf einen Wert unterhalb des Umgebungsdrucks verstanden.

Der Begriff "Mengenfluß" umfaßt zum einen den Massenstrom, zum anderen den Volumenstrom der betreffenden Substanz.

Mit "Vakuumpumpe" wird allgemein ein Gerät bezeichnet, das in einem abgeschlossenen Raum die Dichte der darin enthaltenen Gase und damit den Druck erniedrigt und so der Erzeugung, Verbesserung und/oder Aufrechterhaltung eines Druckes unterhalb des Umgebungsdrucks dient.

Die Zusammenhänge zwischen dem Partialdruck des Precursors und den Mengenströmen des Trägergases sowie des Precursors lassen sich beispielsweise in Bezug auf den Gesamtdruck und den Sättigungsdampfdruck des Precursors darstellen. Der Partialdruck des Precursors entspricht dabei dem Molenbruch des Precursors in der Gasphase multipliziert mit dem Gesamtdruck. Mit der Bedingung gemäß der Erfindung, daß der Partialdruck des Precursors unterhalb seines Sättigungsdampfdruckes liegen muß, läßt sich beispielsweise für die Massenströme des Precursors beziehungsweise des Trägergases unter Berücksichtigung der jeweiligen molaren Massen eine Beziehung zum Verhältnis des Sättigungsdampfdruckes des Precursors zum Gesamtdruck herleiten.

In der Erfindung kann die Kontrolleinrichtung daher derart konfiguriert sein, daß sie unter Ansprechen auf den Massenfluß des Precursors den Massenfluß des Trägergases unter Berücksichtigung des Gesamtdruckes sowie der molaren Massen von Precursor und Trägergas und des Sättigungsdampfdruckes des Precursors so regelt, daß der Partialdruck des gasförmigen Precursors unterhalb seines Sättigungsdampfdrucks gehalten wird.

Indem eine Steuerung beziehungsweise Regelung des Precursors und des Trägergases unter Berücksichtigung des Sättigungsdampfdruckes ermöglicht wird, bietet die Erfindung den Vorteil einer einfachen und zuverlässigen Abstimmung der Substanzen unter den jeweils herrschenden Betriebsbedingungen aufeinander, ohne daß weitere Größen mit zusätzlichen Meßeinrichtungen erfaßt werden müssen. Dadurch wird die erfindungsgemäße Vorrichtung besonders kompakt und ist vorteilhafterweise zudem wenig störanfällig. Mit Hilfe der Erfindung wird daher ein bei Raumtemperatur fester und/oder flüssiger Precursor in verdampfter Form der Weiterverarbeitung derart zugeführt, daß das Kondensieren des Precursors zuverlässig unterbunden wird.

Erfindungsgemäß umfaßt die Kontrolleinrichtung einen ersten Massenflußregler (MFC) für den gasförmigen Precursor im ersten Leitungsabschnitt und/oder einen zweiten Massenflußregler (MFC) für das Trägergas im zweiten Leitungsabschnitt. Massenflußregler bieten eine robuste und in weiten Druckbereichen einsetzbare Lösung für die Mengenstromregelung beziehungsweise -steuerung des Precursors und des Trägergases.

Um die Fördereinrichtung besonders einfach handhaben zu können; ist gemäß der Erfindung vorgesehen, daß die Kontrolleinrichtung einen Speicher umfaßt, in welchem zumindest ein Sättigungsdampfdruck eines Precursors abgelegt werden kann, wobei der Speicher insbesondere mit dem ersten und/oder zweiten Massenflußregler verbindbar ist. Wird die Fördereinrichtung im wesentlichen für denselben Precursor eingesetzt, kann der Benutzer im Speicher dessen Sättigungsdampfdruck ablegen, so daß dieser Wert ohne weitere Schritte immer zur Verfügung steht.

In einer vorteilhaften Weiterbildung für eine für eine flexible Anwendung der Fördereinrichtung für unterschiedliche Precursor sieht die Erfindung vor, daß die Kontrolleinrichtung einen Speicher umfaßt, in welchem für mehrere Precursor zumindest die Werte des Sättigungsdampfdrucks jedes Precursors abgelegt ist, und eine Eingabeeinrichtung, welche es einem Benutzer erlaubt, einen Precursor für eine anstehende Förder- und Dosieraufgabe auszuwählen. Im Speicher können in weiteren Ausführungsformen dieser Weiterbildung auch die molaren Massen, die Dichten und weitere geeignete Größen von Precursorn und Trägergasen abgelegt sein.

Insbesondere wenn eine Weiterverarbeitung bei einem Druck unterhalb des Umgebungsdruckes durchgeführt werden soll, die Vakuumpumpe jedoch einen Ausgangsdruck hat, welcher dme Umgebungsdruck entspricht, sieht die Erfindung vorteilhafterweise ein Drosselventil vor dem Eintritt in die Weiterverarbeitung vor. Dazu umfaßt die Fördereinrichtung in einer entsprechenden Ausführungsform einen dritten Leitungsabschnitt für die Zuführung zumindest des verdampften Precursors zur Weiterverarbeitung auf der Auslaßseite der Vakuumpumpe, wobei der dritte Leitungsabschnitt ein Ventil zum Einstellen und/oder Steuern und/oder Regeln des Ausgangsdruckes umfaßt. Dadurch wird der Pumpe ein konstanter Ausgangsdruck angeboten, so daß die Erfindung flexibel für unterschiedliche Anforderungen an die Betriebsparameter eingesetzt werden kann.

Gemäß der Erfindung wird der Ausgangsdruck pₐᵤₛ, mit welchem die Mischung des gasförmigen Precursors und des Trägergases die Vakuumpumpe verläßt, in einer vorteilhaften Weiterbildung eingestellt und/oder geregelt und/oder gesteuert.

Um das Verdampfen des festen und/oder flüssigen Precursors zu unterstützen, sieht die Erfindung in einer vorteilhaften Weiterbildung vor, daß die Fördereinrichtung eine erste Beheizungseinrichtung zum Beheizen des ersten Leitungsabschnittes, insbesondere vom Vorlagegefäß bis zum ersten Massenflußregler, umfaßt. zusätzlich oder alternativ kann eine zweite Beheizungseinrichtung zum Beheizen des ersten Leitungsabschnittes vom ersten Massenflußregler bis zum Eintritt in die Vakuumpumpe vorgesehen werden. Ebenso liegt es im Rahmen der Erfindung, in einer weiteren Ausführungsform eine dritte Beheizungseinrichtung zum Beheizen der Vakuumpumpe zur Verfügung zu stellen. Zudem kann die Fördereinrichtung zusätzlich oder alternativ eine vierte Beheizungseinrichtung zum Beheizen des dritten Leitungsabschnittes nach dem Auslaß aus der Vakuumpumpe aufweisen. Je nachdem, an welcher Stelle bei der jeweiligen Anwendung die größte Kondensationsgefahr herrscht, bietet die Erfindung die Möglichkeit, flexibel die jeweiligen Leitungsabschnitte und/oder die Vakuumpumpe beziehungsweise ihren Schöpfraum derart zu temperieren, daß die Prozeßbedingungen in sicherem Abstand von den Kondensationsbedingungen gehalten werden.

In vorteilhaften weiterbildungen der Erfindung kann somit die Temperatur T₁ des gasförmigen Precursors in einem Leitungsabschnittes vom Vorlagegefäß bis zum ersten Massenflußregler und/oder die Temperatur T₂ des gasförmigen Precursors in einem Leitungsabschnittes vom ersten Massenflußregler bis zum Eintritt in die Vakuumpumpe und/oder die Temperatur T₃ des gasförmigen Precursors und/oder des Trägergases in der Vakuumpumpe und/oder die Temperatur T₄ der Mischung des gasförmigen Precursors und des Trägergases in einem Leitungsabschnitt nach Austritt aus der Vakuumpumpe eingestellt und/oder gesteuert und/oder geregelt werden.

Je nach Anwendungsgebiet bietet die Erfindung verschiedene Möglichkeiten, den Precursor zu verdampfen und zu fördern beziehungsweise zu dosieren. So kann beispielsweise eine mehrstufige Vakuumpumpe eingesetzt werden. Die Vakuumpumpe kann insbesondere aus der Gruppe ausgewählt werden, welche Membranpumpen, Turbopumpen, Scrollpumpen und Drehschieberpumpen umfaßt. Bei einer mehrstufigen Pumpe sieht die Erfindung vor, daß in einer vorteilhaften Weiterbildung das Trägergas an der letzten Stufe der Vakuumpumpe zudosiert wird, das heißt, so spät wie möglich, denn die Gefahr für Kondensation steigt mit zunehmender Verdichtung.

Allgemein ist hier auch ein Verfahren beschrieben zum Fördern und Dosieren eines gasförmigen Precursors zur Weiterverarbeitung mit folgenden Schritten:
a) Bereitstellen eines bei Raumtemperatur und Atmosphärendruck festen und/oder flüssigen Precursors,
b) Verdampfen des festen und/oder flüssigen Precursors zumindest durch Absenken des Druckes über dem festen und/oder flüssigen Precursor zum Bereitstellen eines gasförmigen Precursors unter Verwendung einer Vakuumpumpe,
c) Mischen des gasförmigen Precursors mit einem Trägergas in der Vakuumpumpe,
wobei die Mengenströme des gasförmigen Precursors und des Trägergases derart aufeinander abgestimmt werden, daß der Partialdruck des gasförmigen Precursors zumindest nach Eintritt in die Vakuumpumpe unterhalb seines Sättigungsdampfdrucks gehalten wird.

Mit dem erfindungsgemäßen Verfahren gemäß Anspruch 1 kann eine Vielzahl von Precursor-Substanzen bearbeitet werden. Beispielsweise ist gemäß der Erfindung der Precursor aus der Gruppe ausgewählt, welche TiCl₄, SnCl₄, NbCl₅, TaCl₅, AlCl₃, SiCl₄, Hexamethyldisiloxan (HMDSO), Hexamethyldisilazan (HMDSN), Tetramethyldisiloxan (TMDSO) und Tetraoxysilan (Tetraethylortholsilicat, TEOS) umfaßt.

Um auch bei Nutzung der Erfindung für eine Vielzahl verschiedener Precursor eine besonders benutzerfreundliche und zuverlässige Handhabung des Verfahrens zu ermöglichen, sieht die Erfindung in einer Weiterbildung vor, daß für mehrere Precursor zumindest die Werte des Sättigungsdampfdrucks jedes Precursors gespeichert werden und unter Ansprechen auf die Auswahl eines Precursors für eine anstehende Förder- und Dosieraufgabe durch einen Benutzer für die Regelung und/oder Steuerung der Mengen des gasförmigen Precursors und des Trägergases zur Verfügung gestellt werden.

Die Erfindung betrifft außerdem die Verwendung eines oben beschriebenen Verfahrens bei der Förderung und Dosierung eines bei Raumtemperatur und Atmosphärendruck festen und/oder flüssigen Precursors zur Weiterverarbeitung in einem Beschichtungsverfahren. Dabei kann das Beschichtungsverfahren beispielsweise aus der Gruppe ausgewählt sein, welche chemische Gasphasenabscheidung. (chemical vapour deposition, CVD), chemische Gasphasenabscheidung durch Verbrennung (combustion chemical vapour deposition, CCVD), insbesondere Flammpyrolyse, Plasma induzierte chemische Gasphasenabscheidung (plasma enhanced chemical vapour deposition, PECVD) und gepulste Plasma induzierte chemische Gasphasenabscheidung (plasma impulse chemical vapour deposition, PICVD) umfaßt.

Dabei bietet die Erfindung den Vorteil, daß bei Raumtemperatur und Atmosphärendruck fester und/oder flüssiger Precursor ohne die erfindungsgemäße simultane Verdampfung, Förderung und Dosierung nicht gasförmig, sondern flüssig dosiert werden müßte. Insbesondere für bei Raumtemperatur und Atmosphärendruck feste Precursor bedeutet dies den Einsatz eines Lösungsmittels. Ein Lösungsmittel als weitere Substanz im Prozeß könnte jedoch gerade für die oben genannten Verfahren die Durchführung einer Beschichtung empfindlich stören.

Die Erfindung wird nachfolgend anhand von Ausführungsbeispielen unter Bezugnahme auf die beigefügten Zeichnungen näher erläutert. Dieselben Bauteile sind in allen Figuren mit denselben Bezugszeichen versehen. Es zeigen:
- Figur 1: eine schematische Darstellung einer Fördereinrichtung gemäß einer ersten Ausführungsform der Erfindung,
- Figur 2: eine schematische Darstellung einer Fördereinrichtung gemäß einer zweiten Ausführungsform der Erfindung,
- Figur 3: eine schematische Darstellung einer Fördereinrichtung gemäß einer dritten Ausführungsform der Erfindung, und
- Figur 4: eine schematische Darstellung einer Fördereinrichtung gemäß einer vierten Ausführungsform der Erfindung.

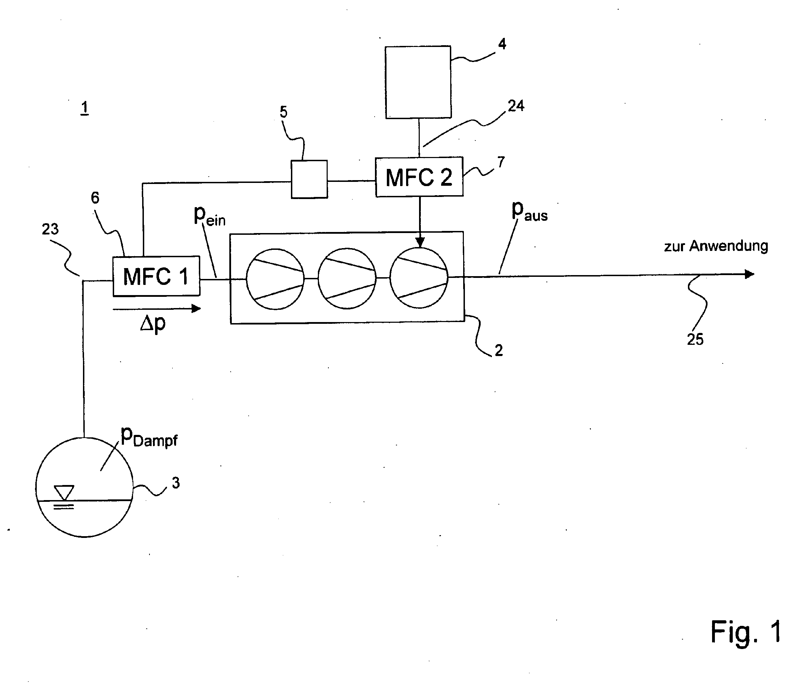

Die in Figur 1 schematisch dargestellte Fördereinrichtung 1 gemäß einer ersten Ausführungsform der Erfindung umfaßt ein Vorlagengefäß 3, in welchem ein Precursor vorgelegt wird. Der Precursor wird in fester und/oder flüssiger Form bereitgestellt. Ein erster Leitungsabschnitt 23 verbindet das Vorlagengefäß 3 mit einer Vakuumpumpe 2, so daß die Vakuumpumpe über den Leitungsabschnitt 23 das Vorlagengefäß 3 evakuieren kann, um den Precursor zu verdampfen. Der Precursor tritt gasförmig mit einem Druck pₑᵢₙ in die Vakuumpumpe 2 ein.

In den gezeigten Ausführungsbeispielen wird eine dreistufige Vakuumpumpe 2 eingesetzt. Im Rahmen der Erfindung können jedoch auch einstufige oder andere mehrstufige Vakuumpumpen verwendet werden. Insbesondere schließt die Erfindung nicht aus, mehrere Vakuumpumpen in Reihe zu schalten. Gegebenenfalls können ölfreie Vakuumpumpe eingesetzt werden, um eine Verunreinigung des Precursors und/oder des Trägergases durch das Öl zu vermeiden.

In der Vakuumpumpe 2 wird dem Precursor ein Trägergas zugemischt. Das Trägergas wird in einem Vorlagegefäß 4 bereitgestellt. Die Vakuumpumpe verdichtet den Precursor beziehungsweise die Mischung aus Precursor und Trägergas auf einen Druck pₐᵤₛ > pₑᵢₙ, mit welchem die Mischung durch einen dritten Leitungsabschnitt 25 zur Anwendung, das heißt zur weiteren Verarbeitung des Precursors beziehungsweise der Mischung des Precursors und des Trägergases gefördert wird.

Die Mengenströme an Precursor und Trägergas, welche aus den jeweiligen Vorlagebehältern 3, 4 der Vakuumpumpe 2 zugeführt werden, sind derart aufeinander abgestimmt, daß zumindest in der Vakuumpumpe 2 ein Kondensieren des Precursors vermieden wird. Dazu ist eine Kontrolleinrichtung 5 vorhanden, welche mit einem ersten Massenflußregler (MFC1) 6 und einem zweiten Massenflußregler (MFC2) 7 verbunden ist. Bei der Verbindung der Kontrolleinrichtung 5 mit den Massenflußreglern 6, 7 kann es sich um drahtgebundene oder drahtlose Verbindungen handeln.

Wird beispielsweise der Massenfluß des Precursors durch eine entsprechende Vorgabe mittels des ersten Massenflußreglers 6 festgelegt, wird über die Kontrolleinrichtung 5 der zweite Massenflußregler 7 dazu veranlaßt, den Massenfluß des Trägergases derart festzulegen, daß der Partialdruck des Precursors in der Mischung aus Trägergas und Precursor unterhalb des Sättigungsdampfdruckes des Precursors bleibt.

Der Begriff "festlegen" umfaßt hier das Einstellen oder Steuern oder Regeln, je nachdem, wie die Kontrolleinrichtung 5 ausgebildet ist. Beispielsweise kann die Kontrolleinrichtung 5 für eine Ausgestaltung als Regeleinrichtung in den Figuren nicht dargestellte Meßeinrichtungen für die Massenflüsse des Precursors und/oder der Mischung aus Precursor und Trägergas beziehungsweise für den Gesamtdruck in der Mischung aus Precursor und Trägergas aufweisen.

Bei der Auslegung einer derartigen Fördereinrichtung 1 ist zu beachten, daß insbesondere der erste Massenflußregler 6 einen Druckverlust Δp (Delta p) aufweist. Die Vakuumpumpe 2 ihrerseits weist einen bestimmten minimalen Eingangsdruck pₑᵢₙ auf. Beide Größen bestimmen, welche Precursor mit der Fördereinrichtung einer Weiterverarbeitung zugeführt werden können, denn der Dampfdruck p_{Dampf} des Precursors muß mindestens so groß sein wie die Summe aus pₑᵢₙ und Δp.

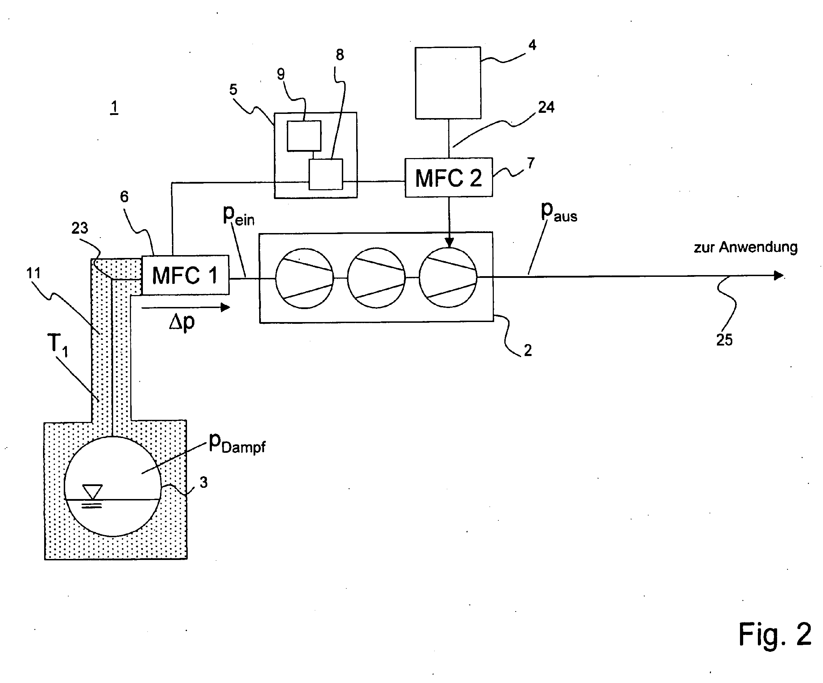

In einer weiteren Ausführungsform, welche in Figur 2 schematisch dargestellt ist, weist die Fördereinrichtung 1 eine Kontrolleinrichtung 5 auf, welche einen Speicher 8 umfaßt. Der Speicher 8 weist mehrere Speicherplätze auf, in welchen zumindest Werte für den jeweiligen Sättigungsdampfdruck mehrerer Precursor-Substanzen abgelegt sind. Des weiteren können beispielsweise auch Werte für die molaren Massen der mehreren Precursor-Substanzen in dem Speicher 8 abgelegt sein.

Der Speicher 8 ist verbunden mit einer Eingabeeinrichtung 9. Über die Eingabeeinrichtung 9 kann ein Benutzer einen Precursor auswählen, welcher für die beabsichtigte Anwendung eingesetzt werden soll. Unter Ansprechen auf diese Auswahl greift die Kontrolleinrichtung 5 über den Speicher 8 auf den Wert des Sättigungsdampfdruckes genau dieses Precursors zu. Je nachdem, wie die Kontrolleinrichtung 5 konfiguriert ist, kann die Kontrolleinrichtung auch auf den Wert für die molare Masse des Precursors zugreifen. Unter Heranziehung dieser Werte aus dem Speicher 8 werden dann mittels der Komtrolleinrichtung 5 über die Massenflußregler 6, 7 die Massenströme des Precursors und des Trägergases derart eingestellt beziehungsweise gesteuert beziehungsweise geregelt, daß der Partialdruck des Precursors unterhalb seines Sättigungsdampfdruckes gehalten wird.

Die Fördereinrichtung 1 weist zusätzlich eine erste Beheizungseinrichtung 11 auf, mit welcher das Vorlagengefäß 3 des Precursors und ein Teil des ersten Leitungsabschnitts 23, nämlich der Teil vom Vorlagengefäß 3 des Precursors bis zum ersten Massenflußregler 6, auf eine Temperatur T₁ beheizt werden kann.

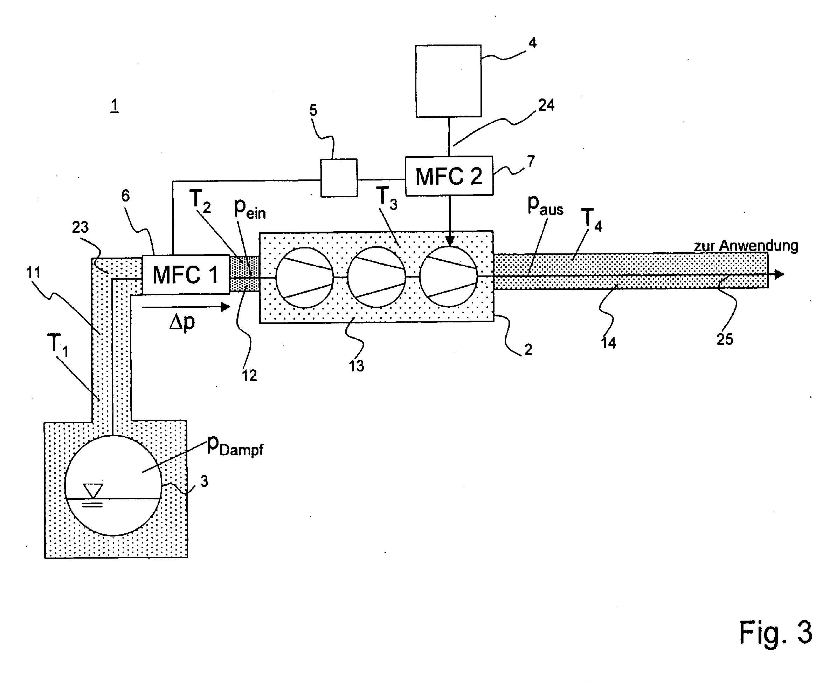

In einer weiteren Ausführungsform, welche in Figur 3 schematisch dargestellt ist, weist die Fördereinrichtung 1 zusätzlich eine zweite Beheizungseinrichtung 12 auf, mit welcher der Teil des ersten Leitungsabschnitts 23 vom ersten Massenflußregler 6 bis zum Eintritt in die Vakuumpumpe 2 auf eine Temperatur T₂ beheizt werden kann. Die Vakuumpumpe 2 ist mittels einer dritten Beheizungseinrichtung 13 auf eine Temperatur T₃ beheizbar. Die Beheizungseinrichtung 13 kann insbesondere derart gestaltet sein, daß im wesentlichen nur der Schöpfraum der Vakuumpumpe 2 auf die Temperatur T₃ geheizt wird, und die übrigen Komponenten der Vakuumpumpe 2 unbeheizt bleiben. Zudem weist die Fördereinrichtung 1 eine vierte Beheizungseinrichtung 14 auf, mit welcher der dritte Leitungsabschnitt 25 vom Ausgang der Vakuumpumpe 2 hin zur Anwendung, das heißt der Weiterverarbeitung, auf eine Temperatur T₄ beheizt werden kann.

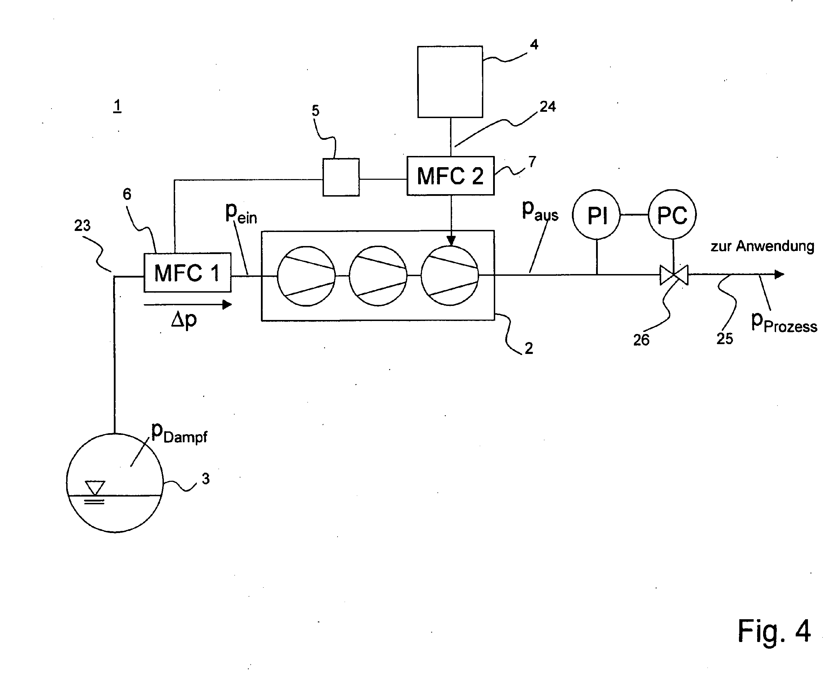

In einer weiteren, in Figur 4 schematisch dargestellten Ausführungsform der Erfindung weist die Fördereinrichtung 1 nach dem Ausgang aus der Vakuumpumpe 2 im dritten Leitungsabschnitt 25 ein Drosselventil 26 auf. In der dargestellten Weiterbildung ist das Drosselventil über einen Druckregler PC regelbar. Der Druckregler PC ist mit einem Druckaufnehmer PI verbunden, welcher den Istwert des Druckes pₐᵤₛ mißt. Ist der Prozeßdruck p_{prozeß} kleiner als der Ausgangsdruck pₐᵤₛ der Vakuumpumpe, regelt der Druckregler PC unter Ansprechen auf den Istwert pₐᵤₛ das Ventil 26 zur Einstellung des Druckes p_{prozeß}. Somit kann eine nahezu beliebige Vakuumpumpe, deren Ausgangsdruck gleich Atmosphärendruck ist, auch für Anwendungen bei Unterdruck eingesetzt werden, denn das Drossel-Regelsystem bietet der Pumpe einen konstanten Ausgangsdruck an.

Es ist dem Fachmann ersichtlich, dass die Erfindung nicht auf die vorstehend beschriebenen Ausführungsbeispiele beschränkt ist, sondern vielmehr in vielfältiger Weise variiert werden kann. Insbesondere können die Merkmale der einzelnen Ausführungsbeispiele auch miteinander kombiniert oder gegeneinander ausgetauscht werden.

### Bezugszeichenliste

- 1: Förder- und Dosiereinrichtung
- 2: Vakuumpumpe
- 23: ersten Leitungsabschnitt
- 24: zweiter Leitungsabschnitt
- 25: dritter Leitungsabschnitt
- 26: Ventil
- 3: Vorlagengefäß für einen Precursor
- 4: Vorlagengefäß für Trägergas
- 5: Kontrolleinrichtung
- 6: erster Massenflußregler
- 7: zweiter Massenflußregler
- 8: Speicher
- 9: Eingabeeinrichtung
- 11: erste Beheizungseinrichtung
- 12: zweite Beheizungseinrichtung
- 13: dritte Beheizungseinrichtung
- 14: vierte Beheizungseinrichtung

## Patentansprüche

1. Verfahren zum Fördern eines gasförmigen Precursors zur Weiterverarbeitung mit folgenden Schritten:
a) Bereitstellen eines bei Raumtemperatur und Atmosphärendruck festen und/oder flüssigen Precursors in einem Vorlagegefäß (3) für den festen und/oder flüssigen Precursor,
b) Verdampfen des festen und/oder flüssigen Precursors zumindest durch Absenken des Druckes über dem festen und/oder flüssigen Precursor zum Bereitstellen eines gasförmigen Precursors unter Verwendung einer Vakuumpumpe (2), wobei ein erster Leitungsabschnitt (23) auf einer Einlaßseite der Vakuumpumpe (2) eine Verbindung zwischen der Vakuumpumpe (2) und dem Vorlagegefäß (3) herstellt,
c) Mischen des gasförmigen Precursors mit einem Trägergas in der Vakuumpumpe (2), wobei das Trägergas über zumindest einen zweiten Leitungsabschnitt (24) zugeführt wird,
**dadurch gekennzeichnet, dass**
die Mengenströme des gasförmigen Precursors und des Trägergases mittels einer Kontrolleinrichtung (5) derart aufeinander abgestimmt werden, daß der Partialdruck des gasförmigen Precursors zumindest nach Eintritt in die Vakuumpumpe (2) unterhalb seines Sättigungsdampfdrucks gehalten wird, indem
die Kontrolleinrichtung (5) mit dem ersten und dem zweiten Leitungsabschnitt (23, 24) verbunden ist und den Mengenfluß des gasförmigen Precursors und/oder des Trägergases steuert und/oder regelt, wobei
die Kontrolleinrichtung (5) einen Speicher (8) umfaßt, in welchem zumindest ein Sättigungsdampfdruck eines Precursors abgelegt ist, und
der Speicher (8) mit einem ersten Massenflußregler (6) für den gasförmigen Precursor in dem ersten Leitungsabschnitt (23) und/oder einem zweiten Massenflußregler (7) für das Trägergas in dem zweiten Leitungsabschnitt (24) verbunden ist.

2. Verfahren nach Anspruch 1,
**dadurch gekennzeichnet, daß**
der Precursor aus der Gruppe ausgewählt wird, welche TiCl₄, SnCl₄, NbCl₅, TaCl₅, AlCl₃, SiCl₄, Hexamethyldisiloxan (HMDSO), Hexamethyldisilazan (HMDSN), Tetramethyldisiloxan (TMDSO) und Tetraoxysilan (Tetraethylortholsilicat, TEOS) umfaßt.

3. Verfahren nach Anspruch 1 oder 2,
**dadurch gekennzeichnet, daß**
für mehrere Precursor die Werte des Sättigungsdampfdrucks jedes Precursors gespeichert werden und unter Ansprechen auf die Auswahl eines Precursors für eine anstehende Förder- und/oder Dosieraufgabe durch einen Benutzer für die Regelung und/oder Steuerung der Mengenflüsse des gasförmigen Precursors und des Trägergases zur Verfügung gestellt werden.

4. Verfahren nach einem der Ansprüche 1 bis 3,
**dadurch gekennzeichnet, daß**
der Ausgangsdruck pₐᵤₛ, mit welchem die Mischung des gasförmigen Precursors und des Trägergases die Vakuumpumpe (2) verläßt, eingestellt und/oder geregelt und/oder gesteuert wird.

5. Verfahren nach einem der Ansprüche 1 bis 4,
**dadurch gekennzeichnet, daß**
die Temperatur T₁ des gasförmigen Precursors zumindest in dem Teil des ersten Leitungsabschnittes (23) vom Vorlagegefäß (3) bis zum ersten Massenflußregler (6) eingestellt und/oder gesteuert und/oder geregelt wird.

6. Verfahren nach einem der Ansprüche 1 bis 5,
**dadurch gekennzeichnet, daß**
die Temperatur T₂ des gasförmigen Precursors zumindest in dem Teil des ersten Leitungsabschnittes (23) vom ersten Massenflußregler (6) bis zum Eintritt in die vakuumpumpe (2) eingestellt und/oder gesteuert und/oder geregelt wird.

7. Verfahren nach einem der Ansprüche 1 bis 6,
**dadurch gekennzeichnet, daß**
die Temperatur T₃ des gasförmigen Precursors und/oder des Trägergases in der Vakuumpumpe (2) eingestellt und/oder gesteuert und/oder geregelt wird.

8. verfahren nach einem der Ansprüche 1 bis 7,
**dadurch gekennzeichnet, daß**
die Temperatur T₄ der Mischung des gasförmigen Precursors und des Trägergases zumindest in einem Teil des dritten Leitungsabschnittes (25) nach Austritt aus der Vakuumpumpe (2) eingestellt und/oder gesteuert und/oder geregelt wird.

9. Verwendung eines Verfahrens nach einem der Ansprüche 1 bis 8 bei der Förderung und/oder Dosierung eines bei Raumtemperatur und Atmosphärendruck festen und/oder flüssigen Precursors zur Weiterverarbeitung in einem Beschichtungsverfahren.

10. Verwendung nach Anspruch 9,
wobei das Beschichtungsverfahren aus der Gruppe ausgewählt ist, welche
chemische Gasphasenabscheidung (chemical vapour deposition, CVD),
chemische Gasphasenabscheidung durch Verbrennung (combustion chemical vapour deposition, CCVD), insbesondere Flammpyrolyse,
Plasma induzierte chemische Gasphasenabscheidung (plasma enhanced chemical vapour deposition, PECVD) und
gepulste Plasma induzierte chemische Gasphasenabscheidung (plasma impulse chemical vapour deposition, PICVD)
umfaßt.

## Claims

1. Method for feeding a gaseous precursor for further processing, having the following steps:
a) providing a precursor which is solid and/or liquid at room temperature and atmospheric pressure in a receiving vessel (3) for the solid and/or liquid precursor,
b) vaporising the solid and/or liquid precursor at least by reducing the pressure over the solid and/or liquid precursor in order to provide a gaseous precursor, using a vacuum pump (2), wherein a first line section (23) on an inlet side of the vacuum pump (2) produces a connection between the vacuum pump (2) and the receiving vessel (3),
c) mixing the gaseous precursor with a carrier gas in the vacuum pump (2), wherein the carrier gas is supplied via at least one second line section (24), **characterised in that**
the flow rates of the gaseous precursor and of the carrier gas are matched to one another by means of a control device (5) such that the partial pressure of the gaseous precursor is kept below its saturation vapour pressure, at least after it enters the vacuum pump (2), **in that**
the control device (5) is connected to the first and second line sections (23, 24) and controls and/or regulates the flow rate of the gaseous precursor and/or of the carrier gas, wherein
the control device (5) includes a memory (8) in which at least a saturation vapour pressure of a precursor is stored, and
the memory (8) is connected to a first mass flow regulator (6) for the gaseous precursor in the first line section (23) and/or to a second mass flow regulator (7) for the carrier gas in the second line section (24).

2. Method as claimed in Claim 1, **characterised in that** the precursor is selected from the group including TiCl₄, SnCl₄, NbCl₅, TaCl₅, AlCl₃, SiCl₄, hexamethyldisiloxane (HMDSO), hexamethyldisilazane (HMDSN), tetramethyldisiloxane (TMDSO) and tetraoxysilane (tetraethyl orthosilicate, TEOS).

3. Method as claimed in Claim 1 or 2, **characterised in that** the values of the saturation vapour pressure of each precursor are stored for a plurality of precursors, and are made available for regulation and/or control of the flow rates of the gaseous precursor and of the carrier gas in response to the selection of one precursor for an incipient feed and/or metering task by a user.

4. Method as claimed in any one of Claims I to 3, **characterised in that** the output pressure pₒᵤₜ at which the mixture of the gaseous precursor and of the carrier gas leaves the vacuum pump (2) is set and/or regulated and/or controlled.

5. Method as claimed in any one of Claims 1 to 4, **characterised in that** the temperature T₁ of the gaseous precursor is set and/or controlled and/or regulated at least in the part of the first line section (23) from the receiving vessel (3) to the first mass flow regulator (6).

6. Method as claimed in any one of Claims 1 to 5, **characterised in that** the temperature T₂ of the gaseous precursor is set and/or controlled and/or regulated at least in the part of the first line section (23) from the first mass flow regulator (6) to entry into the vacuum pump (2).

7. Method as claimed in any one of Claims 1 to 6, **characterised in that** the temperature T₃ of the gaseous precursor and/or of the carrier gas is set and/or controlled and/or regulated in the vacuum pump (2).

8. Method as claimed in any one of Claims 1 to 7, **characterised in that** the temperature T₄ of the mixture of the gaseous precursor and of the carrier gas is set and/or controlled and/or regulated at least in a part of the third line section (25) after exit out of the vacuum pump (2).

9. Use of a method as claimed in any one of Claims 1 to 8 for feeding and/or metering a precursor which is solid and/or liquid at room temperature and atmospheric pressure, for further processing in a coating method.

10. Use as claimed in Claim 9, wherein the coating method is selected from the group including:
chemical vapour deposition (CVD),
combustion chemical vapour deposition (CCVD), in particular flame pyrolysis,
plasma enhanced chemical vapour deposition (PECVD), and
plasma impulse chemical vapour deposition (PICVD).

## Revendications

1. Procédé pour transporter un précurseur gazeux pour le traitement ultérieur présentant les étapes suivantes :
a) mise à disposition d'un précurseur solide et/ou liquide à la température ambiante et à la pression atmosphérique dans un récipient de réserve (3) pour le précurseur solide et/ou liquide,
b) évaporation du précurseur solide et/ou liquide au moins par abaissement de la pression au-dessus du précurseur solide et/ou liquide pour la mise à disposition d'un précurseur gazeux avec l'utilisation d'une pompe à vide (2), un premier tronçon de conduite (23) établissant sur un côté entrée de la pompe à vide (2) une liaison entre la pompe à vide (2) et le récipient de réserve (3),
c) mélange du précurseur gazeux avec un gaz porteur dans la pompe à vide (2), le gaz porteur étant amené au moyen d'au moins un second tronçon de conduite (24),
**caractérisé en ce que** :
les flux massiques du précurseur gazeux et du gaz porteur sont adaptés les uns aux autres au moyen d'un dispositif de contrôle (5) de telle sorte que la pression partiellè du précurseur gazeux est maintenue au moins après l'entrée dans la pompe à vide (2) au-dessous de sa pression de vapeur de saturation du fait que :
le dispositif de contrôle (5) est relié au premier et au second tronçons de conduite (23, 24) et commande et/ou règle le débit massique du précurseur gazeux et/ou du gaz porteur,
le dispositif de contrôle (5) comprenant une mémoire (8), dans laquelle est déposée au moins une pression de vapeur de saturation d'un précurseur, et
la mémoire (8) étant reliée à un premier régulateur de débit (6) pour le précurseur gazeux dans le premier tronçon de conduite (23) et/ou à un second régulateur de débit (7) pour le gaz porteur dans le second tronçon de conduite (24).

2. Procédé selon la revendication 1,
**caractérisé en ce que** :
le précurseur est sélectionné dans le groupe qui comprend TiCl₄, SnCl₄, NbCl₅, TaCl₅, AlCl₃, SiCl₄, hexaméthyldisiloxane (HMDSO), hexaméthyldisilazane (HMDSN), tétraméthyldisiloxane (TMDSO) et tétraoxysilane (tétraéthylorthosilicate, TEOS).

3. Procédé selon la revendication 1 ou 2,
**caractérisé en ce que** :
les valeurs de la pression de saturation de chaque précurseur sont sauvegardées pour plusieurs précurseurs et sont mises à disposition en réaction au choix d'un précurseur pour une tâche de transport et/ou de dosage imminente par un utilisateur pour le réglage et/ou la commande des débits du précurseur gazeux et du gaz porteur.

4. Procédé selon l'une des revendications 1 à 3,
**caractérisé en ce que** :
la pression de sortie pₐᵤₛ, avec laquelle le mélange du précurseur gazeux et du gaz porteur quitte la pompe à vide (2), est ajustée et/ou réglée et/ou commandée.

5. Procédé selon l'une des revendications 1 à 4,
**caractérisé en ce que** :
la température T₁ du précurseur gazeux est ajustée et/ou commandée et/ou réglée au moins dans la partie du premier tronçon de conduite (23) allant du récipient de réserve (3) jusqu'au premier régulateur de débit (6).

6. Procédé selon l'une des revendications 1 à 5,
**caractérisé en ce que** :
la température T₂ du précurseur gazeux est ajustée et/ou commandée et/ou réglée au moins dans la partie du premier tronçon de conduite (23) depuis le premier régulateur de débit (6) jusqu'à l'entrée dans la pompe à vide (2).

7. Procédé selon l'une des revendications 1 à 6,
**caractérisé en ce que** :
la température T₃ du précurseur gazeux et/ou du gaz porteur est ajustée et/ou commandée et/ou réglée dans la pompe à vide (2).

8. Procédé selon l'une des revendications 1 à 7,
**caractérisé en ce que** :
la température T₄ du mélange du précurseur gazeux et du gaz porteur est ajustée et/ou commandée et/ou réglée au moins dans une partie du troisième tronçon de conduite (25) après la sortie de la pompe à vide (2).

9. Utilisation d'un procédé selon l'une des revendications 1 à 8, lors du transport et/ou du dosage d'un précurseur solide et/ou liquide à la température ambiante et la pression atmosphérique pour le traitement ultérieur dans un procédé de revêtement.

10. Utilisation selon la revendication 9,
le procédé de revêtement étant choisi dans le groupe qui comprend :
le dépôt chimique en phase gazeuse (chemical vapour deposition, CVD),
le dépôt chimique en phase gazeuse par combustion (combustion chemical vapour deposition, CCVD),
en particulier la pyrolyse à flamme,
le dépôt chimique en phase gazeuse induite par plasma (plasma enhanced chemical vapour deposition, PECVD), et
le dépôt chimique en phase gazeuse induite par des impulsions de plasma (plasma impulse chemical vapour deposition, PICVD).
